(19) **Europäisches Patentamt**
**European Patent Office**
**Office européen des brevets**

(11) **EP 1 953 769 A1**

(12) **EUROPEAN PATENT APPLICATION**
published in accordance with Art. 158(3) EPC

(43) Date of publication:
**06.08.2008 Bulletin 2008/32**

(51) Int Cl.:
*H01B 13/00* (2006.01)  *C22C 9/02* (2006.01)
*C22C 27/02* (2006.01)  *C22F 1/00* (2006.01)
*C22F 1/08* (2006.01)  *H01B 12/10* (2006.01)
*H01F 6/06* (2006.01)

(21) Application number: **06822768.5**

(22) Date of filing: **01.11.2006**

(86) International application number:
**PCT/JP2006/321839**

(87) International publication number:
**WO 2007/060819 (31.05.2007 Gazette 2007/22)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **22.11.2005 JP 2005337821**

(71) Applicant: **KABUSHIKI KAISHA KOBE SEIKO SHO Kobe-shi,**
**Hyogo 651-8585 (JP)**

(72) Inventors:
• **MIYAZAKI, Takayoshi,**
c/o Kobe Corporate Res. Lab.
**Hyogo 651-2271 (JP)**

• **NANBA, Shigenobu,**
c/o Kobe Corporate Res. Lab.
**Hyogo 651-2271 (JP)**
• **ZAITSU, Kyoji,**
c/o Kobe Corporate Res. Lab.
**Hyogo 651-2271 (JP)**

(74) Representative: **TBK-Patent**
**Bavariaring 4-6**
**80336 München (DE)**

(54) **Nb-CONTAINING ROD-SHAPED MATERIAL FOR USE IN MANUFACTURE OF SUPERCONDUCTING WIRE AND METHOD FOR MANUFACTURE OF Nb3Sn SUPERCONDUCTING WIRE**

(57)    It is an object to provide a Nb-based rod material which is used for producing a $Nb_3Sn$ superconducting wire material and in which satisfactory workability in Nb or a Nb-based alloy can be achieved, and a method of producing a superconducting wire material which can exhibit satisfactory superconducting characteristics using the Nb-based rod material. The Nb-based rod material is produced by a step of casting a raw material of this rod material using a casting mold having a circular or substantially circular cross-sectional shape, and a step of forming a columnar or substantially columnar rod material by hot-working or cold-working the resulting product obtained by the casting with a working apparatus whose cross-sectional shape is a circular or substantially circular shape.

**EP 1 953 769 A1**

**Description**

Technical Field

The present invention relates to a useful method of producing a $Nb_3Sn$ superconducting wire material and to a Nb-based rod material for producing a superconducting wire material, the rod material being used as a raw material in the production method.

Background Art

An example of an application in which a superconducting wire material has been in practical use is its use as a superconducting magnet used in a high-resolution nuclear magnetic resonance (NMR) analyzer. The higher the magnetic field generated by the superconducting magnet, the higher the resolution of the NMR analyzer. Therefore, recently, there has been an increase in the magnetic field generated by such a superconducting magnet.

As a superconducting wire material used for such a superconducting magnet for high-magnetic-field generation, a $Nb_3Sn$ wire material has been practically used. A bronze process is mainly employed for producing this $Nb_3Sn$ superconducting wire material.

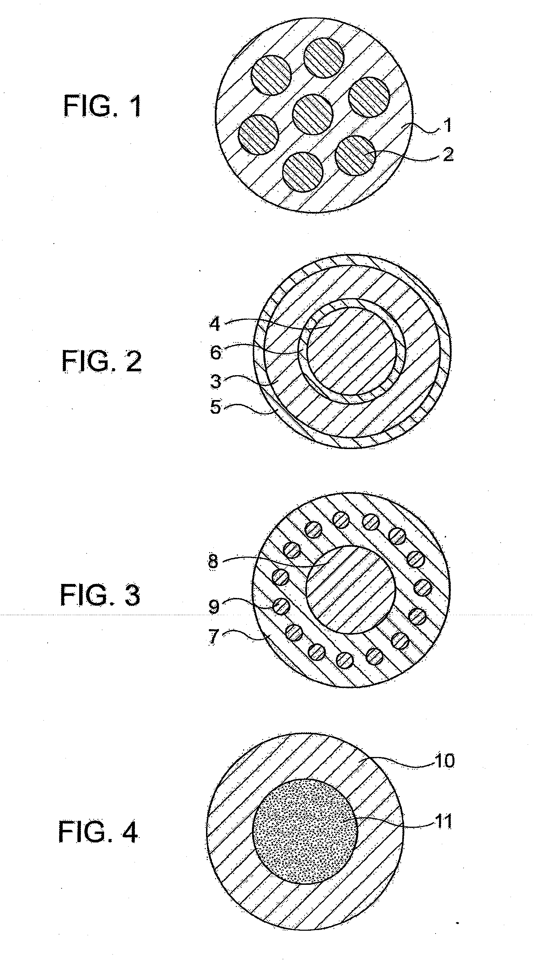

In the bronze process, a composite material for producing a $Nb_3Sn$ superconducting wire material that is schematically shown in Fig. 1 is used. In this composite material, a plurality of (in Fig. 1, seven) core members 2 made of Nb or a Nb-based alloy are embedded in a Cu-Sn-based alloy (bronze) matrix 1. These core members 2 are subjected to wire drawing, thereby reducing the diameter thereof. Thus, the core members 2 are formed into filaments. A plurality of the composite materials including the filaments of the core members 2 and the bronze are bundled to form a group of wire materials. Copper (stabilizing Cu) for stabilization is arranged on the outer surface of the group of wire materials, and wire drawing is then performed. After the wire drawing has been performed, the group of wire materials is subjected to a heat treatment (diffusion heat treatment) at about 600°C or higher and 800°C or lower, thereby forming a $Nb_3Sn$ compound layer at the interface between the filaments and the matrix.

In addition to the above bronze process, as a process of producing a $Nb_3Sn$ superconducting wire material, a tube process, an internal diffusion process, a powder process, and the like are also known.

Among these processes, in the tube process, a composite material for producing a $Nb_3Sn$ superconducting wire material that is schematically shown in Fig. 2 is used. In this composite material, a core member 4 made of Sn or a Sn-based alloy is arranged in a tube (pipe member) 3 made of Nb or a Nb-based alloy. This composite material is inserted in a Cu pipe 5, as needed; subjected to a diameter-reducing process such as wire drawing; and then heat-treated. Accordingly, a diffusion reaction between Nb and Sn occurs, thus producing $Nb_3Sn$ (for example, Patent Document 1). Furthermore, from the viewpoint of workability, a Cu pipe 6 may be arranged between the core member 4 and the Nb tube 3 (for example, Patent Document 2).

In the internal diffusion process, a composite material for producing a $Nb_3Sn$ superconducting wire material that is schematically shown in Fig. 3 is used. In this composite material, a core member 8 made of Sn or a Sn-based alloy is embedded at the central part of a base material 7 made of Cu or a Cu-based alloy, and a plurality of (in the figure, 15) core members 9 made of Nb or a Nb-based alloy are arranged in the base material 7 and around the core member 8. This composite material is subjected to wire drawing and then heat-treated. Accordingly, Sn in the core member 8 diffuses and reacts with Nb in the core members 9, thus producing $Nb_3Sn$ (for example, Patent Document 3).

In the powder process, a composite material for producing a $Nb_3Sn$ superconducting wire material that is schematically shown in Fig. 4 is used. This composite material is produced by a step of forming a powder core part 11 by filling a sheath (pipe member) 10 made of Nb or a Nb-based alloy with a raw material powder containing at least Sn (for example, a Ta-Sn-based powder), and a step of further inserting the sheath 10 and the powder core part 11 into a Cu billet (not shown). This composite material is subjected to a diameter-reducing process such as extruding or wire drawing to formed into a wire material. Subsequently, the wire material is wound around a magnet or the like and then heat-treated. Accordingly, a $Nb_3Sn$ superconducting phase is formed from the inner surface side of the sheath 10.

For convenience of explanation, a single-core composite material is shown in Figs. 2 to 4. However, in practical use, a multi-core composite material in which a plurality of single cores are arranged in a Cu matrix is generally used.

Furthermore, it has been proposed that, in producing a superconducting wire material using the above composite material, elements such as Ti, Ta, Zr, and Hf are added to the $Nb_3Sn$ phase. It is believed that the addition of these elements in a $Nb_3Sn$ superconducting wire material improves superconducting characteristics of the superconducting wire material at high magnetic fields, compared with a $Nb_3Sn$ superconducting wire material not containing these elements. For example, Patent Document 4 describes that adding Ti to the Sn metal core (core member 8 in Fig. 3) in an amount of 30 atomic percent or less and adding Ti to the Nb metal cores (core members 9 in Fig. 3) in an amount of 5 atomic percent or less can improve the critical current density Jc of the superconducting wire material in an external magnetic field of 15 T (Tesla) or more.

In the production of the superconducting wire material, since a diameter-reducing process such as extruding or wire drawing is performed for a composite material used as a precursor of the superconducting wire material, a wire material having a circular cross-sectional shape is generally used as the composite material. Furthermore, in some cases, after the composite material is worked to a certain degree, hexagonal drawing, which is a drawing for changing the cross-sectional shape of the composite material to a hexagon, is performed. Several or several hundreds of the raw materials having a hexagonal cross section are combined to form a multi-core composite wire material, and wire drawing is further performed for this composite wire material. In addition, in the case where workability is degraded during drawing, intermediate annealing may be performed. Thus, wire drawing of the composite material is performed until the diameter of the composite material, which is about several tens to several hundreds millimeters before the wire drawing, is reduced to several microns.

In such wire drawing with a high working ratio, it is necessary that the cross-sectional shape of the raw material be uniformly changed by the wire drawing. In each of the above processes, Nb or a Nb-based alloy is used as a raw material (a pipe member or a core member). When wire drawing with a high working ratio is performed for this raw material, a phenomenon in which the circular cross section of the raw material made of Nb or a Nb-based alloy in the composite material cannot be maintained and is changed to a cross section having the shape of a rhombus or a rectangle may occur. Furthermore, as described above, in the case where elements such as Ti, Ta, Zr, and Hf are added to Nb or a Nb-based alloy used as a raw material in order to improve the characteristics of the final superconducting wire material, the addition of these elements degrades workability instead, and thus, the above phenomenon may occur more easily.

The above phenomenon causes breaking of a wire material in the course of drawing. Alternatively, the above phenomenon may cause problems such as a decrease in the critical current density (Jc), a decrease in the n-value (a value used as an indicator showing the sharpness of the transition from the superconducting state to the normal conducting state), and an increase in the AC loss in the final superconducting wire material.

In view of the above circumstances, hitherto, the occurrence of the above problems has been prevented by adjusting the drawing ratio so as not to change the cross-sectional shape of the raw material, that is, by preparing a raw material for drawing having a small cross-sectional area in advance and working the raw material with a relatively low working ratio. However, the production efficiency in this method is extremely low. Accordingly, it has been desired to establish a technique in which a satisfactory working can be realized without deformation even when a raw material for drawing having a large cross-sectional area is used.

[Patent Document 1] Japanese Unexamined Patent Application Publication No. 52-16997
[Patent Document 2] Japanese Unexamined Patent Application Publication No. 3-283320
[Patent Document 3] Japanese Unexamined Patent Application Publication No. 49-114389
[Patent Document 4] Japanese Examined Patent Application Publication No. 1-8698

Disclosure of Invention

The present invention has been made in order to meet the above desire. It is an object of the present invention to provide a Nb-based rod material which is used for producing a $Nb_3Sn$ superconducting wire material and in which workability of Nb or a Nb-based alloy can be satisfactory, and to provide a useful method of producing a superconducting wire material which exhibits satisfactory superconducting characteristics (in particular, the critical current density and the n-value) using the Nb-based rod material.

To achieve this object, the present invention provides a Nb-based rod material used for producing a superconducting wire material, wherein the Nb-based rod material is formed to be columnar or substantially columnar by casting a raw material of the Nb-based rod material using a casting mold having a circular or substantially circular cross-sectional shape, and by hot-working or cold-working with a working apparatus whose cross-sectional shape is a circular or substantially circular shape.

In the Nb-based rod material made of Nb or a Nb-based alloy, the Nb-based rod material is preferably formed so that a circular cross-sectional shape or a substantially circular cross-sectional shape is maintained through the steps of the hot-working or the cold-working.

Furthermore, in the Nb-based rod material made of Nb or a Nb-based alloy, more preferably, for example, the following requirements are satisfied: (a) the crystal grain size of the rod material is in the range of 5 to 100 $\mu$m (and more preferably, in the range of 5 to 50 $\mu$m); (b) the concentration of at least one type of element selected from the group consisting of carbon, nitrogen, oxygen, and hydrogen is 200 ppm or less; (c) the rod material contains at least one type of element selected from the group consisting of Ti, Ta, Zr, and Hf in an amount in the range of 0.1 to 20 mass percent; and (d) the rod material contains Nb in an amount of 70 mass percent or more.

Furthermore, the present invention provides a production method for achieving the above object including a first step of forming a composite material for producing a superconducting wire material by combining a hot-worked or cold-worked columnar or substantially columnar Nb-based rod material with Cu or a Cu-based alloy and Sn or a Sn-based alloy, or a Cu-Sn-based alloy; a second step of forming a precursor wire material for producing a superconducting wire material by reducing the diameter of the combined composite material for producing a superconducting wire material to form a wire material; and a third step of forming a superconducting phase by heat-treating the precursor wire material for producing a superconducting wire material.

In this production method, for example, when a composite material for producing a superconducting wire material is formed by combining the columnar or substantially columnar Nb-based rod material with a Cu-Sn-based alloy, a bronze process or an internal diffusion process can be employed. Alternatively, when a composite material for producing a superconducting wire material is formed by processing a columnar or substantially columnar Nb-based rod material into a cylindrical or cylindrical shape, and then combining the Nb-based rod material with Cu or a Cu-based alloy and Sn or a Sn-based alloy, a powder process or a tube process can be employed.

Brief Description of Drawings

Fig. 1 is a cross-sectional view that schematically shows a composite material used in a bronze process.
Fig. 2 is a cross-sectional view that schematically shows a composite material used in a tube process.
Fig. 3 is a cross-sectional view that schematically shows a composite material used in an internal diffusion process.
Fig. 4 is a cross-sectional view that schematically shows a composite material used in a powder process.

Best Modes for Carrying Out the Invention

The present inventors have studied from various angles the cause of uneven deformation of Nb or a Nb-based alloy (an alloy containing at least Nb in an amount of 70 mass percent or more), which is used as a member of a composite material for producing a superconducting wire material, generated by wire-drawing the composite material. As a result, present inventors have found that a specific aggregate texture is formed in accordance with the history of the production process, and this aggregate texture is a cause of the uneven deformation. It is believed that since Nb or a Nb-based alloy is not easily recrystallized, the above phenomenon of the formation of the specific aggregate texture significantly occurs. Furthermore, even if Nb or the Nb-based alloy is recrystallized, the recrystallized aggregate texture tends to deform the circular cross-sectional shape before wire drawing to a rectangular or rhombic cross-sectional shape.

In a stage of casting, Nb or a Nb-based alloy is formed as a cast slab having a circular or rectangular cross-sectional shape. In the subsequent stage of workings (hot working and cold working), the cross-sectional shape is changed to a rectangle, a rhombus, or an ellipse. Finally, Nb or the Nb-based alloy is provided as a raw material for a composite material having a circular cross section or a rectangular cross section. In the raw material produced by such a process, corner portions of the cross-sectional shape (four portions in the case of a rectangle) are significantly deformed, and a specific aggregate texture is significantly developed at the portions. These portions having the developed aggregate texture are in a state in which the shape of the material is not easily changed. It is believed that this makes it difficult to perform uniform working in the subsequent wire drawing stage, and thus, the cross-sectional shape of the material becomes a distorted shape.

Consequently, the present inventors have conducted intensive studies on an aggregate texture that can prevent uneven deformation. As a result, it has been found that when a raw material has an aggregate texture which is axially symmetric with respect to the center in the cross section, the cross-sectional shape is not changed to a rectangle or a rhombus even in the later stage of wire drawing, and the drawing can be continued while maintaining a circular shape or a substantially circular shape. Note that the term "substantially circular shape" includes not only a shape that is not a perfect circle but is approximately a circle, but also a hexagonal cross-sectional shape.

An aggregate texture that is desired in the present invention is an axially symmetric structure. In order to obtain such an aggregate texture, casting is performed using a casting mold having a circular or a substantially circular cross section in the stage of casting, and working is performed using a working apparatus having a circular or a substantially circular cross section.

More specifically, it has been found that, through a production process, when a process during which the cross section of a material is constantly subjected to axial symmetry (a process during which a circular cross section of a material is maintained) is performed, the above preferable aggregate texture is developed. In particular, in the case where workings (hot working and cold working) are performed, the above finding does not merely mean that the final cross-sectional shape is a circular or substantially circular shape, but means that the material is preferably processed so as to maintain a circular shape or substantially circular shape in all the steps. Note that the hot working in the present invention includes hot rolling, hot forging, and the like. The cold working in the present invention includes cold rolling, cold forging, and the like.

In the Nb-based rod material made of Nb or a Nb-based alloy of the present invention, the average crystal grain size thereof is preferably in the range of 5 to 100 $\mu$m, and more preferably in the range of 5 to 50 $\mu$m. This crystal grain size affects the workability. When the average crystal grain size is less than 5 $\mu$m, work hardening significantly occurs, and thus, cracking easily occurs during wire drawing.

On the other hand, as the average crystal grain size increases, the workability (ductility) becomes more satisfactory. However, when the average crystal grain size exceeds 100 $\mu$m, the surface property is degraded (irregularities are easily formed on the surface). Consequently, when such a Nb-based rod material is formed into a composite material, a deformation resistance with an adjacent member increases, and uniform working may become difficult. When the size (diameter) of a casting mold is small, a sufficient working ratio is not ensured, and the grain size may be larger than the above range. In such a case, upset forging in which compression is performed in the longitudinal direction may be performed.

In the Nb or Nb-based alloy rod of the present invention, carbon, nitrogen, oxygen, hydrogen, and other elements are contained as inevitable impurities. These are elements forming an interstitial solid solution (interstitial elements). If an excessive amount of these elements are contained, work hardening excessively occurs, and thus forming and working may become difficult. Therefore, the total concentration of these elements is preferably 200 ppm or less. On the other hand, the lower limit of the concentration of these elements is not particularly determined, but this concentration is preferably 20 ppm or more. The superconducting wire material to be produced is a composite material of the Nb or Nb-based alloy rod and copper or a copper alloy. Accordingly, if the content of these elements is excessively small, a difference in the deformation resistance between the Nb or Nb-based alloy rod and copper or a copper alloy disposed at the periphery of the rod is excessively large. This difference in the deformation resistance induces uneven deformation, such as sausaging and a ribbon-shaped deformation, during the formation of the composite material and may cause degradation of characteristics.

The average crystal grain size can be controlled by processings such as casting and rolling and by an adjustment by annealing. The concentration of the above impurities can be reduced by, for example, decreasing the degree of vacuum during melting of the alloy, or melting repeatedly in a high vacuum atmosphere.

The Nb or Nb-based alloy rod contains at least one type of element selected from the group consisting of Ti, Ta, Zr, and Hf in an amount in the range of 0.1 to 20 mass percent, as needed. These elements are effective in improving superconducting characteristics (in particular, the critical current density Jc) of the final wire material. In order to achieve this effect, the content of the above elements is preferably 0.1 mass percent or more. However, a content exceeding 20 mass percent degrades the workability.

In producing the superconducting wire material using the above-described Nb or Nb-based alloy rod, a uniform working can be performed in which a substantially circular cross-sectional shape of Nb or the Nb-based alloy, which is formed into filaments, can be maintained, and the current distribution in the cross section can be uniform. As a result, the critical current density Jc and the n-value can be improved. Furthermore, an appropriate control of the crystal grain size as described above can decrease the contact resistance with a member adjacent to the Nb or Nb-based alloy and suppress coupling between the filaments, thus decreasing the AC loss in the superconducting wire material.

The Nb$_3$Sn-based superconducting wire material including the above Nb-based alloy rod for producing a superconducting wire material can be produced in accordance with a known method. For example, the production of the superconducting wire material is preferably performed by a method including the following steps (a) to (c):

(a) a step of forming a composite material for producing a superconducting wire material by combining a hot-worked or cold-worked columnar or substantially columnar Nb-based rod material with Cu or a Cu-based alloy and Sn or a Sn-based alloy, or a Cu-Sn-based alloy;
(b) a step of forming a precursor wire material for producing a superconducting wire material by reducing the diameter of the combined composite material for producing a superconducting wire material to form a wire material; and
(c) a step of forming a superconducting phase by heat-treating the precursor wire material for producing a superconducting wire material.

In this method of producing a superconducting wire material, by combining a columnar or substantially columnar Nb-based rod material with, for example Cu or a Cu-based alloy and Sn or a Sn-based alloy, or a Cu-Sn-based alloy, the composite materials for producing a superconducting wire material shown in Figs. 1 and 2 can be formed, and these composite materials can be used for the bronze process or the internal diffusion process. In addition, by processing a columnar or substantially columnar Nb-based rod material into a cylindrical or cylindrical shape, and then combining the Nb-based rod material with Cu or a Cu-based alloy and Sn or a Sn-based alloy, the composite materials for producing a superconducting wire material shown in Figs. 3 and 4 can be formed, and these composite materials can be used for a powder process or a tube process. In the powder process, a powder mainly composed of Sn (for example, a Ta-Sn powder) is used as the Sn-based alloy. That is, such a powder is also included in the Sn-based alloy to be combined.

The present invention will now be described more specifically using examples. However, the present invention is not limited to the examples below. The present invention can be carried out by adding an appropriate modification within the scope that can be fitted with the points described above or below, and such modifications are also included in the technical scope of the present invention.

[EXAMPLE 1]

Niobium (Nb) rods are produced by casting using a cylindrical casting mold having an inner diameter of 300 mm and then rolled under the following condition (A) or condition (B) until the final diameter of the rods is reduced to 14 mm.

(A) 4-pass hot rolling is performed using a rolling mill in which the rolling cross-sectional shape is a circle, and 4-pass hot rolling is then performed using a rolling mill in which the rolling cross-sectional shape is an ellipse.
(B) 4-pass hot rolling is performed using a rolling mill in which the rolling cross-sectional shape is a circle.
In both a Nb rod obtained under condition (A) (hereinafter referred to as "Nb rod A") and a Nb rod obtained under condition (B) (hereinafter referred to as "Nb rod B"), the concentration of inevitable impurities can be reduced by controlling conditions for melting by means of an electron beam (EB). More specifically, the intensity of the beam, the cross-sectional area of the beam, the output of the beam and the number of times of melting, the degree of vacuum during melting, and the like are controlled. Thereby, among the inevitable impurities, the concentration of carbon
(C) is reduced to 30 ppm, the concentration of nitrogen (N) is reduced to 20 ppm, the concentration of oxygen (O) is reduced to 20 ppm, and the concentration of hydrogen (H) is reduced to 10 ppm. According to the measurement results of the average crystal grain size after rolling, both the Nb rod A and the Nb rod B have an average crystal grain size of 100 $\mu$m.

Each of the Nb rods A and B has an outer diameter of 14 mm and a length of 200 mm. Composite materials in which seven Nb rods A or seven Nb rods B are embedded in a Cu-15 mass% Sn-0.3 mass% Ti alloy having an outer diameter of 67 mm are prepared (refer to Fig. 1). Each of these composite materials undergoes extruding and wire drawing to produce a wire material (hexagonal single-core wire material) having a regular hexagonal cross section with sides of 2 mm.

These hexagonal single-core wires are cut so as to have a predetermined length, and 673 of the wires are bundled. A Nb diffusion barrier layer having a thickness of 1.5 mm is provided in a Cu tube having an outer diameter of 68 mm and an inner diameter of 160 mm. The bundle of the hexagonal single-core wires is arranged inside the Cu tube, thus producing a multi-core composite material. By performing extrusion and wire drawing of this composite material, a precursor wire material for producing a superconducting wire material having a final wire diameter of 0.3 mm is produced. Subsequently, $Nb_3Sn$-formation heat treatment for the composite material is performed at 700°C for 100 hours to produce a $Nb_3Sn$ superconducting wire material. The critical current density Jc, the n-value, and the AC loss are measured using the $Nb_3Sn$ superconducting wire material.

[Measurement of critical current density Jc]

A sample (superconducting wire material) is energized in an external magnetic field of 18 T in liquid helium, and the generated voltage is measured by a four-probe method. A current value when the measured voltage matches with a predetermined value (a voltage value at which an electric field of 0.1 $\mu$V/cm is generated) is measured as a critical current Ic. The critical current density Jc is determined by dividing the measured critical current Ic by the cross-sectional area corresponding to a non-Cu portion in the cross-sectional area of the wire material.

[Measurement of n-value]

An (Ic-V) curve is obtained by the same measurement as the measurement for the critical current. In this curve, the value of n (i.e., "n-value") is determined as a slope of a curve in which both data of Ic and V between 0.1 $\mu$V/cm and 1.0 $\mu$V/cm are shown by the logarithm. More specifically, the relationship between the current and the voltage is empirically represented by an approximate expression of expression (1) below. The v-value is determined on the basis of this expression.

$$V = Vc(Iop/Ic)n \quad \cdots \quad (1)$$

Here, Iop represents the operation current of a magnet, Ic represents the critical current of a wire material, and Vc represents a reference voltage defining Ic.

[Measurement of Ac loss]

A magnetization curve is measured by a pick-up coil method in a state in which the external magnetic field is swept in the range of ± 3T in liquid helium. The area of this magnetization curve is measured as the AC loss.
The results of the above measurements are shown in Table 1.

[Table 1]

| Nb rod | Critical current density Jc (A/mm$^2$) | n-Value | Ac loss (mJ/cc) ± 3T |
|---|---|---|---|
| A | 165 | 21 | 236 |
| B | 195 | 29 | 195 |

These results show that the superconducting wire material produced using the Nb rod B has a satisfactory critical current density Jc and a satisfactory n-value, and in addition, the AC loss of this superconducting wire material is low.

[EXAMPLE 2]

Niobium (Nb)-7.5 mass% Ta alloy rods are produced by casting using a cylindrical casting mold having an inner diameter of 300 mm and then rolled under the following condition (C) or condition (D) until the final diameter is reduced to 55 mm.

    (C) 4-pass hot rolling is performed using a rolling mill in which the rolling cross-sectional shape is a circle, and 4-pass hot rolling is then performed using a rolling mill in which the rolling cross-sectional shape is a rectangle (Nb-based alloy rod C).
    (D) 4-pass hot rolling is performed using a rolling mill in which the rolling cross-sectional shape is a circle (Nb-based alloy rod D).

In both a Nb rod obtained under condition (C) (hereinafter referred to as "Nb-based alloy rod C") and a Nb rod obtained under condition (D) (hereinafter referred to as "Nb-based alloy rod D"), the concentration of inevitable impurities can be reduced by controlling conditions for melting by means of EB. More specifically, the concentration of C is reduced to 20 ppm, the concentration of N is reduced to 20 ppm, the concentration of O is reduced to 30 ppm, and the concentration of H is reduced to 10 ppm. According to the measurement results of the average crystal grain size after rolling, both the Nb-based alloy rod C and the Nb-based alloy rod D have an average crystal grain size of 150 $\mu$m.
Next, a perforation process of the Nb-based alloy rods C and D is performed, thus producing pipe members each having an outer diameter of 55 mm, an inner diameter of 30 mm, and a length of 150 mm.
A Ta powder and a Sn powder are weighed such that the atomic ratio of Ta:Sn is 6:5, and the powders are mixed with a V-blender for about 30 minutes. The mixed powder (base powder) thus obtained is heat-treated at 950°C in vacuum for 10 hours and then crushed. Furthermore, 5 mass percent of a Cu powder and 25 mass percent of Sn powder are added to the base powder, thereby allowing a new mixed powder to be prepared.
A plurality of composite materials are prepared by filling the new mixed powder inside each of the pipe members (refer to Fig. 3). These composite materials are inserted into a Cu billet having an outer diameter of 65 mm and an inner diameter of 30 mm. The Cu billet then undergoes extruding and wire drawing, thus forming a wire material having a regular hexagonal cross section with sides of 4 mm, i.e., a hexagonal single-core wire material.
The hexagonal single-core wires thus obtained are cut so as to have a predetermined length, and 163 of the cut wires are bundled. This bundle is arranged inside a Cu tube having an outer diameter of 65 mm and an inner diameter of 58 mm, thus producing a multi-core composite material. By performing extrusion and wire drawing of the composite material, a precursor wire material for producing a superconducting wire material having a final wire diameter of 1.2 mm is produced.
Subsequently, Nb$_3$Sn-formation heat treatment for the precursor wire material is performed at 650°C for 250 hours to produce a Nb$_3$Sn superconducting wire material. The critical current density Jc, the n-value, and the AC loss are measured as in Example 1 using the Nb$_3$Sn superconducting wire material. The results are shown in Table 2.

[Table 2]

| Nb alloy rod | Critical current density Jc (A/mm$^2$) | n-Value | Ac loss (mJ/cc) $\pm$ 3T |
|---|---|---|---|
| C | 230 | 35 | 1,410 |
| D | 345 | 43 | 1,024 |

These results show that the superconducting wire material produced using the Nb rod D has a satisfactory critical current density Jc and a satisfactory n-value, and in addition, the AC loss of this superconducting wire material is low.

In another example, four forging dies having a circular forging cross-sectional shape with different diameters are prepared. Forging is performed in which a Nb rod is repeatedly roundly pressed so that the diameter of the rod is decreased stepwise, using the dies in descending order of size. Thus, a Nb rod is produced. The resulting circular Nb rod produced by forging with dies each having a circular cross section has better characteristics than a forged Nb rod produced by reducing the diameter so as to have a circular shape by pressing with a flat die while a Nb material is rotated.

The Nb-based alloy rods in Example 2 contain Ta. Alternatively, the addition of, for example, Ti, Zr, or Hf to the Nb-based alloy rods is also effective. The content of Nb is preferably 80 mass percent or more.

Industrial Applicability

The present invention provides a Nb-based rod material in which anisotropy is eliminated to enable satisfactory uniform working. In addition, the present invention provides a method of producing a Nb$_3$Sn superconducting wire material which has an excellent critical current density and a large n-value and which can generate a high magnetic field by using the rod material as a raw material. The superconducting wire material thus produced is useful for the realization of, for example, an NMR magnet, a magnet for an accelerator, and a magnet for nuclear fusion which are compact and which can be produced at a low cost.

**Claims**

1.  A Nb-based rod material for producing a superconducting wire material,
    wherein the Nb-based rod material is formed to be columnar or substantially columnar by casting a raw material of the Nb-based rod material using a casting mold having a circular or substantially circular cross-sectional shape, and by hot-working or cold-working with a working apparatus whose cross-sectional shape is a circular or substantially circular shape.

2.  The Nb-based rod material for producing a superconducting wire material according to Claim 1,
    wherein the Nb-based rod material is formed so that a circular cross-sectional shape or a substantially circular cross-sectional shape is maintained through the steps of the hot-working or the cold-working.

3.  The Nb-based rod material for producing a superconducting wire material according to Claim 1 or 2,
    wherein the average crystal grain size of the rod material is in the range of 5 to 100 $\mu$m.

4.  The Nb-based rod material for producing a superconducting wire material according to any one of Claims 1 to 3,
    wherein the concentration of at least one type of element selected from the group consisting of carbon, nitrogen, oxygen, and hydrogen is 200 ppm or less.

5.  The Nb-based rod material for producing a superconducting wire material according to any one of Claims 1 to 4,
    wherein the rod material contains at least one type of element selected from the group consisting of Ti, Ta, Zr, and Hf in an amount in the range of 0.1 to 20 mass percent.

6.  A Nb-based rod material for producing a superconducting wire material,
    wherein the average crystal grain size of the rod material is in the range of 5 to 100 $\mu$m, the concentration of at least one type of element selected from the group consisting of carbon, nitrogen, oxygen, and hydrogen is 200 ppm or less, and the rod material has a columnar shape or a substantially columnar shape.

7.  A method of producing a Nb$_3$Sn superconducting wire material using the Nb-based rod material for producing a superconducting wire material according to any one of Claims 1 to 6, comprising:

a first step of forming a composite material for producing a superconducting wire material by combining a hot-worked or cold-worked columnar or substantially columnar Nb-based rod material with Cu or a Cu-based alloy and Sn or a Sn-based alloy, or a Cu-Sn-based alloy;

(b) a second step of forming a precursor wire material for producing a superconducting wire material by reducing the diameter of the combined composite material for producing a superconducting wire material to form a wire material; and
(c) a third step of forming a superconducting phase by heat-treating the precursor wire material for producing a superconducting wire material.

8. The method of producing a Nb$_3$Sn superconducting wire material according to Claim 7,
wherein the first step includes a step of forming a composite material for producing a superconducting wire material by combining the columnar or substantially columnar Nb-based rod material with Cu or a Cu-based alloy and Sn or a Sn-based alloy, or a Cu-Sn-based alloy, and
the second step and the third step include a bronze process or an internal diffusion process using the composite material formed in the first step.

9. The method of producing a Nb$_3$Sn superconducting wire material according to Claim 7,
wherein the first step includes a step of forming a composite material for producing a superconducting wire material by processing the columnar or substantially columnar Nb-based rod material into a cylindrical or substantially cylindrical shape, and then combining the Nb-based rod material with Cu or a Cu-based alloy and Sn or a Sn-based alloy, and
the second step and the third step include a powder process or a tube process using the composite material formed in the first step.

10. A Nb$_3$Sn superconducting wire material produced by using the Nb-based rod material for producing a superconducting wire material according to any one of Claims 1 to 6.

FIG. 1

FIG. 2

FIG. 3

FIG. 4

## INTERNATIONAL SEARCH REPORT

| International application No. |
| --- |
| PCT/JP2006/321839 |

A. CLASSIFICATION OF SUBJECT MATTER
*H01B13/00*(2006.01)i, *C22C9/02*(2006.01)i, *C22C27/02*(2006.01)i, *C22F1/00* (2006.01)i, *C22F1/08*(2006.01)i, *H01B12/10*(2006.01)i, *H01F6/06*(2006.01)i

According to International Patent Classification (IPC) or to both national classification and IPC

B. FIELDS SEARCHED

Minimum documentation searched (classification system followed by classification symbols)
H01B13/00, C22C9/02, C22C27/02, C22F1/00, C22F1/08, H01B12/10, H01F6/06

Documentation searched other than minimum documentation to the extent that such documents are included in the fields searched
Jitsuyo Shinan Koho          1922-1996   Jitsuyo Shinan Toroku Koho   1996-2007
Kokai Jitsuyo Shinan Koho    1971-2007   Toroku Jitsuyo Shinan Koho   1994-2007

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| X<br>A | JP 2004-342561 A  (Kobe Steel, Ltd.),<br>02 December, 2004 (02.12.04),<br>Par. Nos. [0027] to [0060]<br>(Family: none) | 10<br>1-9 |
| A | JP 2865798 B2  (Fujikura Ltd.),<br>18 December, 1998 (18.12.98),<br>Full text<br>(Family: none) | 1-10 |
| A | JP 3-238158 A  (The Furukawa Electric Co., Ltd.),<br>23 October, 1991 (23.10.91),<br>Full text<br>(Family: none) | 1-10 |

☐  Further documents are listed in the continuation of Box C.          ☐    See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered    to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>22 January, 2007 (22.01.07) | Date of mailing of the international search report<br>30 January, 2007 (30.01.07) |
| --- | --- |
| Name and mailing address of the ISA/<br>Japanese Patent Office | Authorized officer |
| Facsimile No. | Telephone No. |

Form PCT/ISA/210 (second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 52016997 A
- JP 3283320 A
- JP 49114389 A
- JP 1008698 A